# EUROPEAN PATENT SPECIFICATION

(11) **EP 3 226 409 B1**
(45) Date of publication and mention of the grant of the patent: **23.01.2019**
(21) Application number: 17162846.4
(22) Date of filing: 24.03.2017
(51) Int. Cl.: H02P 27/06, G01R 35/00, G01R 19/00, H02M 1/00

(54) **POWER CONVERTING DEVICE AND AIR CONDITIONER**
LEISTUNGSUMWANDLUNGSVORRICHTUNG UND KLIMAANLAGE
DISPOSITIF DE CONVERSION DE PUISSANCE ET CONDITIONNEUR D'AIR

(30) Priority: 28.03.2016 JP 2016064163
(43) Date of publication of application: 04.10.2017
(73) Proprietor: Mitsubishi Heavy Industries, Ltd., Tokyo 108-8215 (JP)
(72) Inventor: TAKAHASHI, Kazuyoshi, Tokyo, 108-8215 (JP); SHIMIZU, Kenji, Tokyo, 108-8215 (JP); SATO, Takeshi, Tokyo, 108-8215 (JP); KAWASHIMA, Kazumasa, Tokyo, 108-8215 (JP)
(74) Representative: Intès, Didier Gérard André

(56) References cited:
- EP-A1- 2 221 955
- EP-A2- 1 753 108
- EP-A2- 2 385 619
- US-A1- 2004 183 498
- US-A1- 2015 015 235

## Description

### [Technical Field]

The present invention relates to a power converting device and an air conditioner.

### [Background Art]

In a power converting device (an inverter system) applied to an air conditioner and the like, it is necessary to detect an input current for input restriction, driving control of a load, and the like. In order to implement such functions, for example, a current transformer is inserted into a power supply input side (a side in which AC power from a commercial power supply flows), an AC voltage generated according to a current that passes through a coil is rectified and smoothed by a diode bridge, an obtained DC voltage is read by an AD converter (a built-in ADC) built into a control IC (a microcomputer) and the like, and thus the input current is detected.

In market needs, in response to demand for cheaper products, it is desirable to remove the above-described current transformer from a circuit configuration because it is an expensive element. Therefore, as a method of detecting a current with low cost, a method in which shunt resistors are inserted into an inverter main circuit line side (a side in which DC power flows) and a DC voltage generated between the shunt resistors is read is performed (for example, refer to Patent Literature 1).

### [Citation List]

### [Patent Literature]

[Patent Literature 1]
Japanese Unexamined Patent Application, First Publication No. 2009-183038 EP 2 385 619 A2 discloses an example of an apparatus including an inverter circuit for converting a DC power into an AC power.

### [Summary of Invention]

### [Technical Problem]

In the above-described form, in order to detect a total current flowing in the inverter main circuit line, it is necessary to insert shunt resistors at a position close to a diode module (a rectifier circuit including a diode bridge). Therefore, since a voltage generated between the shunt resistors serves as a negative potential with respect to a reference potential (a potential serving as a ground for a control IC), it is not possible to satisfy an input rating of a built-in ADC as it is. Therefore, it is necessary to invert a voltage generated between the shunt resistors by applying an op amp (operational amplifier) and the like.

However, since a separate op amp is necessary, a cost reduction effect obtained when a current transformer is removed decreases.

The present invention provides a power converting device and an air conditioner which can be manufactured more cheaply.

### [Solution to Problem]

According to an aspect of the present invention, there is provided a power converting device as defined in claim 1, the power converting device including a rectifier circuit configured to generate DC power from AC power; an inverter circuit configured to generate load drive AC power from the DC power; a high voltage line and a low voltage line that connect the rectifier circuit and the inverter circuit; a shunt resistor that is connected to the rectifier circuit side relative to a ground point along the low voltage line; a total current detection voltage output circuit configured to output a total current detection voltage corresponding to a total current that flows toward the rectifier circuit along the low voltage line; and a control IC configured to detect the total current based on the total current detection voltage, wherein the total current detection voltage output circuit includes a first connection point connected to a voltage source configured to apply a positive fixed voltage; a second connection point connected between the shunt resistor and the rectifier circuit along the low voltage line; and at least two resistive elements that are connected in series between the first connection point and the second connection point, wherein the total current detection voltage obtained by dividing the positive fixed voltage according to the two resistive elements is output to the control IC, so that it is not necessary to invert a negative potential generated by the shunt resistor with respect to the ground point; and wherein an inverter current, that flows into the inverter circuit, is detected with an additional shunt resistor connected to the inverter circuit side relative to the ground point along the low voltage line.

In addition, according to an aspect of the present invention, in the above-described power converting device, a ratio of a sum of resistance values of the two resistive elements included in the total current detection voltage output circuit to a resistance value of the shunt resistor is 10 to the third power or more.

In addition, according to an aspect of the present invention, the control IC acquires the total current detection voltage when the inverter circuit is stopped, calculates an offset value for setting a value of the total current corresponding to the acquired total current detection voltage to zero, and detects the total current based on an offset-corrected total current detection voltage obtained by adding the offset value to the total current detection voltage acquired while the inverter circuit operates.

In addition, according to an aspect of the present invention, the control IC performs moving average processing on the total current detection voltage when the inverter circuit is stopped, and when a difference between the total current detection voltage that is newly acquired and an average value based on the moving average processing exceeds a predetermined determination threshold value, performs the moving average processing with excluding the total current detection voltage that exceeds the determination threshold value.

In addition, according to an aspect of the present invention, the control IC includes a built-in amplifier circuit and detects the total current based on an amplified voltage that is obtained by amplifying the total current detection voltage in the amplifier circuit.

In addition, according to an aspect of the present invention, the control IC acquires the amplified voltage when the inverter circuit is stopped, calculates a gain correction rate for setting a value of the total current corresponding to the acquired amplified voltage to zero, and detects the total current based on a gain-corrected amplified voltage obtained by multiplying the amplified voltage acquired while the inverter circuit operates by the gain correction rate.

In addition, according to an aspect of the present invention, there is provided an air conditioner that includes the above-described power converting device.

### [Advantageous Effects of Invention]

The above-described power converting device and air conditioner can be manufactured more cheaply.

### [Brief Description of Drawings]

Fig. 1 is a diagram showing a circuit configuration of a power converting device according to a first embodiment.
Fig. 2 is a diagram showing a functional configuration of a control IC according to the first embodiment.
Fig. 3 is a diagram showing a specific form of a conversion table according to the first embodiment.
Fig. 4 is a diagram showing a process flow of the control IC according to the first embodiment.
Fig. 5 is a diagram describing a function of the control IC according to the first embodiment.
Fig. 6 is a diagram describing a function of a control IC according to a modified example of the first embodiment.
Fig. 7 is a diagram showing a functional configuration of a control IC according to a second embodiment.
Fig. 8 is a diagram showing a specific form of a conversion table according to the second embodiment.
Fig. 9 is a diagram showing a process flow of a control IC according to the second embodiment.
Fig. 10 is a diagram describing a function of the control IC according to the second embodiment

### [Description of Embodiments]

### <First embodiment>

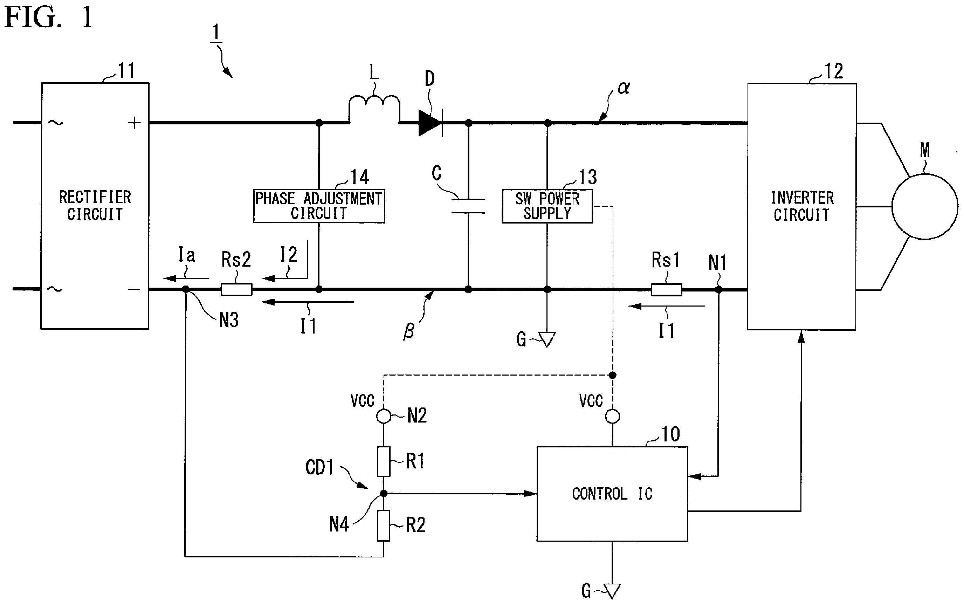

Hereinafter, a power converting device and an air conditioner according to a first embodiment will be described with reference to Fig. 1 to Fig. 5.

### (Circuit configuration of power converting device)

Fig. 1 is a diagram showing a circuit configuration of a power converting device according to the first embodiment.

A power converting device 1 shown in Fig. 1 is installed, for example, in an outdoor unit of an air conditioner, and converts AC power of a defined frequency input from a commercial power supply into AC power for driving a load (a compressor).

As shown in Fig. 1, the power converting device 1 includes a control IC 10, a rectifier circuit 11, an inverter circuit 12, a switching power supply 13, a phase adjustment circuit 14, and a total current detection voltage output circuit CD1.

The control IC 10 is a microcomputer that controls all operations of the power converting device 1 and operates according to a program prepared in advance and thus performs various functions. In particular, the control IC 10 controls an operation of the inverter circuit 12 with reference to an inverter current I1 (to be described below) flowing in the inverter circuit 12 and thus drives a load (a compressor) as desired. In addition, the control IC 10 detects a total current Ia generated in the power converting device 1 and monitors whether the total current Ia exceeds a defined current limit value for a safe operation.

Various functions of the control IC 10 will be described below in detail.

The rectifier circuit 11 includes, for example, a diode bridge circuit, and converts AC power of a predetermined frequency (for example, 50 Hz or 60 Hz) input from a commercial power supply (not shown) into DC power and outputs the converted power. The rectifier circuit 11 outputs a high potential side DC voltage to a high voltage line α shown in Fig. 1 and outputs a low potential side DC voltage to a low voltage line β.

Here, the high voltage line α and the low voltage line β are transmission lines of DC power that connect the rectifier circuit 11 and the inverter circuit 12. DC power output from the rectifier circuit 11 is sent to the inverter circuit 12 through the high voltage line α and the low voltage line β. In addition, the low voltage line β is connected to a ground point G. Therefore, the low potential side DC voltage applied to the low voltage line β is set as a reference potential in other circuit configurations (such as the control IC 10). The high potential side DC voltage with respect to the reference potential (the low potential side DC voltage) is, for example, DC 140 V.

The inverter circuit 12 includes a plurality of switching elements (for example, an insulated gate bipolar transistor (IGBT)) which are not shown. The inverter circuit 12 turns the switching elements on or off based on a control signal from the control IC 10 and thus converts DC power generated in the rectifier circuit 11 into load drive AC power.

The switching power supply 13 is provided between the high voltage line α and the low voltage line β and outputs a positive fixed voltage using a potential (a reference potential) of the ground point G as a reference. Specifically, the switching power supply 13 converts a high potential side DC voltage (DC 140 V) applied to the high voltage line α through the switching element and the like provided therein and stably outputs a positive fixed voltage (for example, DC 5 V) using a reference potential in the low voltage line β as a reference.

The positive fixed voltage output from the switching power supply 13 is a power supply voltage VCC (VCC=5 V) for the above-described control IC 10. Accordingly, the control IC 10 operates based on the power supply voltage VCC provided by the switching power supply 13 and the reference potential provided by the ground point G.

The phase adjustment circuit 14 is provided between the high voltage line α and the low voltage line β and suppresses a harmonic component of an alternating current input to a commercial power supply side. The phase adjustment circuit 14 suppresses a harmonic component of an alternating current through a reactor L, a diode D and a capacitor C according to an on and off operation in an internal switching element.

As shown in Fig. 1, the phase adjustment circuit 14 is connected to an upstream side (a side close to the rectifier circuit 11) relative to the switching power supply 13 along the high voltage line α and the low voltage line β.

In addition, shunt resistors Rs1 and Rs2 whose resistance values are known are connected to the low voltage line β.

The shunt resistor Rs1 is provided to detect the inverter current I1 that flows into the inverter circuit 12.

As shown in Fig. 1, the shunt resistor Rs1 is connected to an upstream side (a side close to the inverter circuit 12) relative to the ground point G at which the reference potential is provided to the switching power supply 13 along the low voltage line β.

The inverter current I1 flowing in the low voltage line β flows out from the inverter circuit 12 and flows into the rectifier circuit 11 through the shunt resistor Rs1 and the ground point G. Here, a voltage drop corresponding to the inverter current 11 is generated in the shunt resistor Rs1. Therefore, a positive potential corresponding to the inverter current I1 is generated between the inverter circuit 12 and the shunt resistor Rs1 (a connection point N1) along the low voltage line β using a potential (a reference potential) of the ground point G as a reference. The control IC 10 acquires the positive potential at the connection point N1 and thus detects the inverter current I1.

On the other hand, the shunt resistor Rs2 is provided to detect the total current Ia in the power converting device 1.

As shown in Fig. 1, the shunt resistor Rs2 is connected to a downstream side (the rectifier circuit 11 side) relative to the ground point G at which the reference potential is provided to the switching power supply 13 and the phase adjustment circuit 14 along the low voltage line β.

The total current Ia flowing in the low voltage line β is a merged current of the inverter current I1 flowing out from the inverter circuit 12 and a phase adjustment circuit current I2 flowing out from the phase adjustment circuit 14. In addition, the total current Ia flows into the rectifier circuit 11 through the ground point G and the shunt resistor Rs2. Here, a voltage drop corresponding to the total current Ia is generated in the shunt resistor Rs2. Therefore, a negative potential (hereinafter referred to as a shunt voltage Vs (Vs≤0)) corresponding to the total current Ia is generated between the shunt resistor Rs2 and the rectifier circuit 11 (a connection point N3) along the low voltage line β using a potential (a reference potential) of the ground point G as a reference. The control IC 10 acquires a positive potential (a total current detection voltage to be described below) corresponding to the shunt voltage Vs at a connection point N2 and thus detects the total current la.

The total current detection voltage output circuit CD1 outputs a total current detection voltage corresponding to the total current Ia flowing toward the rectifier circuit 11 along the low voltage line β toward the control IC 10.

Here, at a first connection point (the connection point N2) of the total current detection voltage output circuit CD1, an output terminal of a voltage source (the switching power supply 13) configured to apply a positive fixed voltage is connected. Therefore, at the first connection point, the positive fixed voltage VCC (the same voltage as the power supply voltage VCC) is applied using a potential (a reference potential) of the ground point G as a reference.

In addition, a second connection point (the connection point N3) of the total current detection voltage output circuit CD1 is connected between the shunt resistor Rs2 and the rectifier circuit 11 along the low voltage line β. Therefore, the shunt voltage Vs (Vs≤0) which is a negative potential corresponding to the total current Ia is applied at the second connection point using a potential (a reference potential) of the ground point G as a reference.

In addition, the total current detection voltage output circuit CD1 includes two resistive elements R1 and R2 that are connected in series between the first connection point (the connection point N2) and the second connection point (the connection point N3). Here, a potential (a total current detection voltage Vi) generated between the resistive element R1 and the resistive element R2 (a connection point N4) is established between the positive fixed voltage VCC (VCC=5 V) at the first connection point and the shunt voltage Vs (Vs≤0) at the second connection point. More specifically, the total current detection voltage Vi at the connection point N4 is a value obtained by dividing a potential difference between the positive fixed voltage VCC and the shunt voltage Vs according to a resistance ratio between the resistive element R1 and the resistive element R2. The total current detection voltage output circuit CD1 outputs the total current detection voltage Vi generated at the connection point N4 toward the control IC 10.

### (Configuration of control IC)

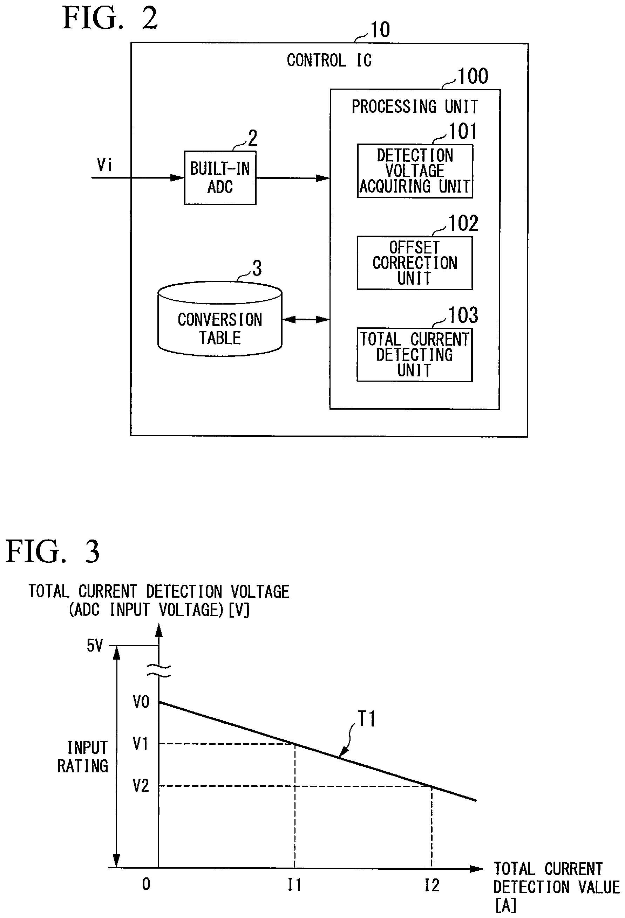

Fig. 2 is a diagram showing a functional configuration of the control IC according to the first embodiment.

As shown in Fig. 2, the control IC 10 includes a processing unit 100, a built-in AD converter (ADC) 2, and a conversion table 3.

The processing unit 100 has a function as a processor that operates according to a program prepared in advance. A specific function of the processing unit 100 will be described below.

The built-in ADC 2 is an AD converter that is integrally formed in the control IC 10. The built-in ADC inputs the total current detection voltage Vi that is an analog voltage, converts the total current detection voltage Vi into a digital sampling value and outputs the converted value. Here, an input rating of the built-in ADC 2 is set as an operation voltage of the control IC 10, that is, a potential between a reference potential (0 V) and the power supply voltage VCC (DC 5 V) (0<Vi<VCC).

The conversion table 3 is a storage area of the control IC. The conversion table 3 is based on an information table in which digital sampling values acquired through the built-in ADC 2 and detection values (a total current detection value) of the predefined total current Ia are in one-to-one correspondence. Content recorded in the conversion table 3 will be described below in detail (refer to Fig. 3).

As shown in Fig. 2, the processing unit 100 performs functions of a detection voltage acquiring unit 101, an offset correction unit 102, and a total current detecting unit 103.

The detection voltage acquiring unit 101 acquires digital sampling data of the total current detection voltage Vi through the built-in ADC 2. Note that, in the following description, digital sampling data of the total current detection voltage Vi acquired by the detection voltage acquiring unit 101 is also simply referred to as a "total current detection voltage Vi."

The offset correction unit 102 acquires the total current detection voltage Vi when the inverter circuit 12 is stopped through the built-in ADC 2 and acquires a total current detection value corresponding to the acquired total current detection voltage Vi with reference to the conversion table 3. Therefore, the offset correction unit 102 calculates an offset value δ for setting the total current detection value acquired when the inverter circuit 12 is stopped to "zero" and temporarily records the value. A specific method of calculating the offset value δ will be described below.

The total current detecting unit 103 detects the total current Ia generated in the power converting device 1 based on the acquired total current detection voltage Vi and the offset value δ calculated by the offset correction unit 102.

That is, the total current detecting unit 103 adds the offset value δ to the total current detection voltage Vi, obtains the offset-corrected total current detection voltage, and reads a total current detection value corresponding to the offset-corrected total current detection voltage from the conversion table 3. The total current detecting unit 103 sets the total current detection value read from the conversion table 3 in this manner as a detection result of the total current la.

Also, the total current detecting unit 103 according to this embodiment detects the total current Ia regularly and repeatedly. Therefore, when the detection result of the total current Ia exceeds a predetermined detection limit value that is defined in advance, the total current detecting unit 103 performs operation control for ensuring safety, for example, emergency stop of an operation of the inverter circuit 12.

Also, the processing unit 100 has general functions other than various functions (the detection voltage acquiring unit 101, the offset correction unit 102 and the total current detecting unit 103) shown in Fig. 2. For example, the processing unit 100 also has a function of detecting the inverter current 11 based on a positive potential generated at the connection point N1, a function of controlling the inverter circuit 12 based on a detection result of the inverter current 11, and the like.

### (Specific form of conversion table)

Fig. 3 is a diagram showing a specific form of the conversion table according to the first embodiment.

The graph in Fig. 3 shows information that is recorded in the conversion table 3 in advance and shows a correspondence relation between the total current detection voltage Vi (a voltage input to the built-in ADC 2) and the total current Ia (the total current detection value).

Here, as described above, the total current detection voltage Vi is a value obtained by dividing a potential difference between the positive fixed voltage VCC and the shunt voltage Vs according to a resistance ratio between the resistive element R1 and the resistive element R2. In addition, the shunt voltage Vs (Vs≤0) decreases (increases as a negative value) as the total current Ia increases. Accordingly, total current detection voltages Vi and total current detection values are in one-to-one correspondence according to a characteristic T1 having a negative correlation as shown in Fig. 3.

Here, when the total current Ia is "0," since the shunt voltage Vs is also "0" (that is, equal to the reference potential), the total current detection voltage Vi when the total current Ia is "0" is a value (V0 shown in Fig. 3) obtained by dividing a potential difference between the positive fixed voltage VCC and the reference potential according to a resistance ratio between the resistive element R1 and the resistive element R2. In addition, a degree (a slope of the graph) of the strength of the negative correlation in the characteristic T1 is uniquely determined by the resistance value of the shunt resistor Rs2. Accordingly, resistance values of the shunt resistor Rs2 and the resistive elements R1 and R2 are determined such that the total current detection voltage Vi (=V2) corresponding to a maximum value (for example, I2 shown in Fig. 3) of a range in which detection of the total current Ia is necessary satisfies an input rating of the control IC 10 (that is, has a positive value).

For example, when a maximum value of the total current Ia is 20 A, in order to set the total current detection voltage Vi (=V2) corresponding to "I2=20 A" when the positive fixed voltage VCC is 5 V as a positive value, the resistance value of the shunt resistor Rs2 is set to 5 mΩ, the resistance value of the resistive element R1 is set to 33 kΩ, and the resistance value of the resistive element R2 is set to 2 kΩ. In this manner, when the total current Ia is 20 A (=12), the total current detection voltage Vi (=V2) is 190 mV. In addition, when the total current Ia is 10 A (=11), the total current detection voltage Vi (=V1) is 240 mV. Furthermore, when the total current Ia is 0 A, the total current detection voltage Vi (=V0) is 290 mV.

As described above, the conversion table 3 according to this embodiment defines a relation (the characteristic T1) between the total current detection voltage Vi (290 mV to 190 mV) calculated based on ideal resistance values (design values) of the resistive elements R1 and R2 and the shunt resistor Rs2 of the total current detection voltage output circuit CD1 and the total current detection value (0 A to 20 A).

However, due to errors in the resistance values of the resistive elements R1 and R2 and the shunt resistor Rs2 and the like, some offset errors are assumed to occur between the total current Ia that actually flows and the total current detection value defined by the conversion table 3 based on the total current detection voltage Vi. Here, as will be described below, the control IC 10 according to this embodiment identifies an offset error in advance, performs a correction process, and thus performs detection of a large current with higher accuracy.

### (Process flow and functions of control IC)

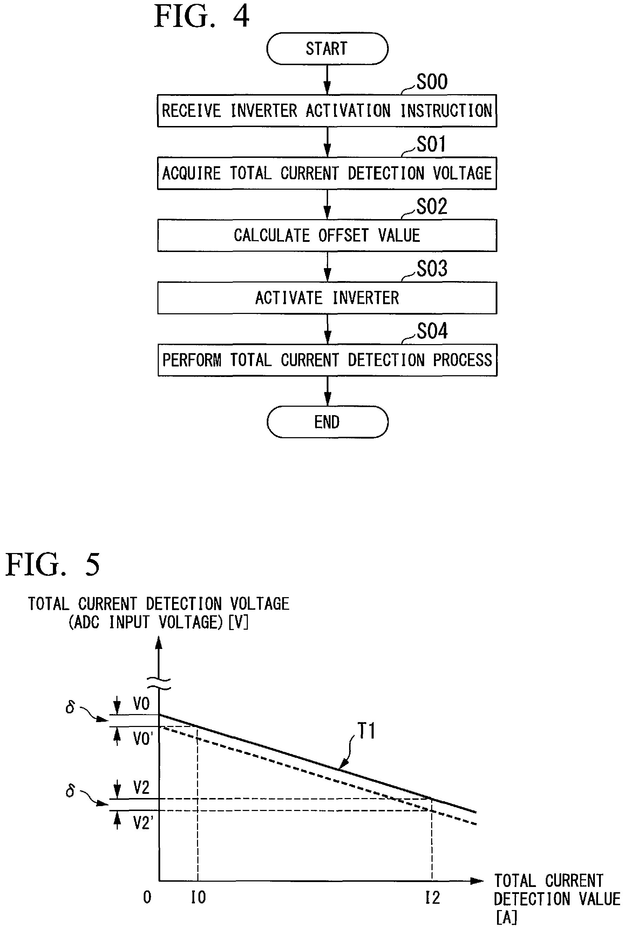

Fig. 4 is a diagram showing a process flow of the control IC according to the first embodiment.

In addition, Fig. 5 is a diagram describing functions of the control IC according to the first embodiment.

The process flow shown in Fig. 4 is performed before an activation instruction of the inverter circuit 12 is issued (while the inverter circuit 12 is stopped).

Before the activation instruction of the inverter circuit 12 is issued, the control IC 10 receives an inverter activation instruction from a higher level (Step S00).

When the inverter activation instruction is received, first, the detection voltage acquiring unit 101 (Fig. 2) of the control IC 10 acquires the total current detection voltage Vi at this stage (a stage in which the inverter circuit 12 is not activated) (Step S01).

Next, based on the total current detection voltage Vi acquired in Step S01, the offset correction unit 102 (Fig. 2) of the control IC 10 calculates the offset value δ for setting the total current detection value corresponding to the total current detection voltage Vi to zero (Step S02).

Hereinafter, functions of the offset correction unit 102 will be described in detail with reference to Fig. 5.

As described above, the resistive elements R1 and R2, the shunt resistor Rs2, and the like include intrinsic errors, and actual resistance values thereof are different from design values. Therefore, the total current detection value acquired through the conversion table 3 (the characteristic T1) in which ideal design values are defined from the total current detection voltage Vi acquired in the stage in which the inverter circuit 12 is not activated (that is, a stage in which the total current Ia is actually zero) is not exactly "zero" in some cases.

Here, for example, the total current detection value acquired in the stage in which the inverter circuit 12 is not activated is "I0" (I0>0) (refer to Fig. 5). Therefore, according to the characteristic T1 defined in the conversion table 3, in the stage in which the inverter circuit 12 is not activated (a stage in which the total current Ia=0), the total current detection voltage Vi that is actually input to the control IC 10 is defined as "V0'" (V0'<V0) instead of "V0."

The offset correction unit 102 calculates V0-V0' based on the total current detection voltage Vi (=V0') acquired in Step S01 and calculates the offset value δ (=V0-V0'). The offset correction unit 102 records the offset value δ calculated here in a predetermined storage area.

Next, in Fig. 4, the control IC 10 activates the inverter circuit 12 in response to the inverter activation instruction received in Step S00 (Step S03). Therefore, in the power converting device 1, the inverter current I1 and the total current Ia flow according to the operation of the inverter circuit 12.

The detection voltage acquiring unit 101 acquires the total current detection voltage Vi input through the total current detection voltage output circuit CD1 while the inverter circuit 12 operates. Then, the total current detecting unit 103 acquires the total current detection value based on the total current detection voltage Vi acquired by the detection voltage acquiring unit 101 and the offset value δ calculated and recorded in Step S02 (Step S04).

Here, operations of the total current detecting unit 103 in Step S04 will be described with reference to Fig. 5.

For example, the actual total current Ia is assumed to be "I2" (I2=20 A) at a certain operation time. In this case, due to errors in the resistance values of the resistive elements R1 and R2, the shunt resistor Rs2, and the like, the total current detection voltage Vi output from the total current detection voltage output circuit CD1 is "V2"' that is deviated from "V2". When the total current detecting unit 103 applies the total current detection voltage Vi (=V2') input here to the characteristic T1 without change, the total current detection value obtained as a result is a value that is different from the actual total current Ia (I2=20 A).

Therefore, the total current detecting unit 103 adds the offset value δ calculated in Step S02 to the total current detection voltages Vi that are sequentially input while the inverter circuit 12 operates and calculates an offset-corrected total current detection voltage (Vi+δ). Then, the total current detecting unit 103 acquires a total current detection value corresponding to the offset-corrected total current detection voltage (Vi+δ) with reference to the conversion table 3.

Therefore, for example, when the total current Ia is "I2," since the offset-corrected total current detection voltage (Vi+δ) is "V2," the total current detection value matches the actual total current Ia (=I2).

Also, while the offset value δ has been described as a positive value in the example shown in Fig. 5, it is conceivable that the offset value δ is a negative value depending on a characteristic of an error. In this case, the total current detecting unit 103 adds a negative offset value δ (δ<0) (in other words, "subtracts" an absolute value of the offset value δ) to the total current detection voltage Vi input while the inverter circuit 12 operates and calculates the offset-corrected total current detection voltage (Vi+δ).

### (Actions and effects)

As described above, the power converting device 1 according to the first embodiment includes the total current detection voltage output circuit CD1 configured to output the total current detection voltage Vi (Vi>0) corresponding to the total current Ia generated in the power converting device 1 toward the control IC 10.

In addition, the total current detection voltage output circuit CD1 includes the first connection point (the connection point N2) connected to a voltage source configured to apply a positive fixed voltage VCC and a second connection point (the connection point N3) connected between the shunt resistor Rs2 and the rectifier circuit 11 along the low voltage line β. In addition, the total current detection voltage output circuit CD1 includes the two resistive elements R1 and R2 that are connected in series between the first connection point and the second connection point, and outputs the total current detection voltage Vi obtained by dividing the positive fixed voltage VCC according to the two resistive elements R1 and R2 to the control IC 10.

In this manner, the total current detection voltage output circuit CD1 for generating a positive voltage that satisfies an input rating of the control IC can be constituted by only the resistive elements R1 and R2. Accordingly, since it is not necessary to invert a negative potential generated by the shunt resistor Rs2 by applying an op amp and the like, it is possible to manufacture the power converting device 1 more cheaply.

In addition, in the power converting device 1 according to the first embodiment, a ratio of a sum of the resistance values of the two resistive elements R1 and R2 included in the total current detection voltage output circuit CD1 to the resistance value of the shunt resistor Rs2 is set to, for example, 10 to the third power or more.

In this manner, according to a current flowing into the connection point N3 through the resistive element R1 and the resistive element R2 from the fixed voltage VCC, it is possible to reduce an influence on the potential (the shunt voltage Vs) at the connection point N3. Accordingly, it is possible to accurately detect the total current la.

In addition, in the power converting device 1 according to the first embodiment, the control IC 10 acquires the total current detection voltage Vi when the inverter circuit 12 is stopped and calculates the offset value δ for setting a value of the total current Ia corresponding to the acquired total current detection voltage Vi to zero. In addition, the control IC 10 detects the total current Ia based on an offset-corrected total current detection voltage that is obtained by adding the offset value δ to the total current detection voltage Vi acquired while the inverter circuit 12 operates.

In this manner, since it is possible to exclude a detection error caused by a resistance value error of the resistive elements R1 and R2 and the shunt resistor Rs2 and the like, it is possible to detect the total current Ia more accurately.

For example, characteristics of electronic components such as a resistive element may vary depending on, in general, an ambient environment temperature and the like. However, for example, as in the process flow shown in Fig. 4, because the offset value δ is recalculated whenever the inverter circuit 12 is activated, it is possible to reduce error factors that are influenced by a change in an ambient environment and the like.

While the power converting device 1 according to the first embodiment has been described above in detail, a specific form of the power converting device 1 is not limited to the above-described form, and various design modifications can be added without departing from the scope of the invention.

For example, in the first embodiment, a form in which the control IC 10 (the offset correction unit 102) calculates the offset value δ immediately before the inverter circuit 12 is activated has been described (refer to Fig. 4). However, other embodiments are not limited to this form.

For example, the control IC 10 according to another embodiment may have a form in which the offset value δ is calculated immediately after an operation of the inverter circuit 12 stops.

In addition, in the first embodiment, a form in which the processing unit 100 of the control IC 10 has a configuration that includes the above-described offset correction unit 102 has been described. However, in other embodiments, the configuration of the offset correction unit 102 may not necessarily be installed. That is, when an error of a current detection value due to an ambient environment, various resistive elements, and the like is within an acceptable range for performing a safe operation, a form in which the total current detection value corresponding to the total current detection voltage Vi input to the control IC 10 is acquired from the conversion table 3 may be used.

### <Modified example of first embodiment>

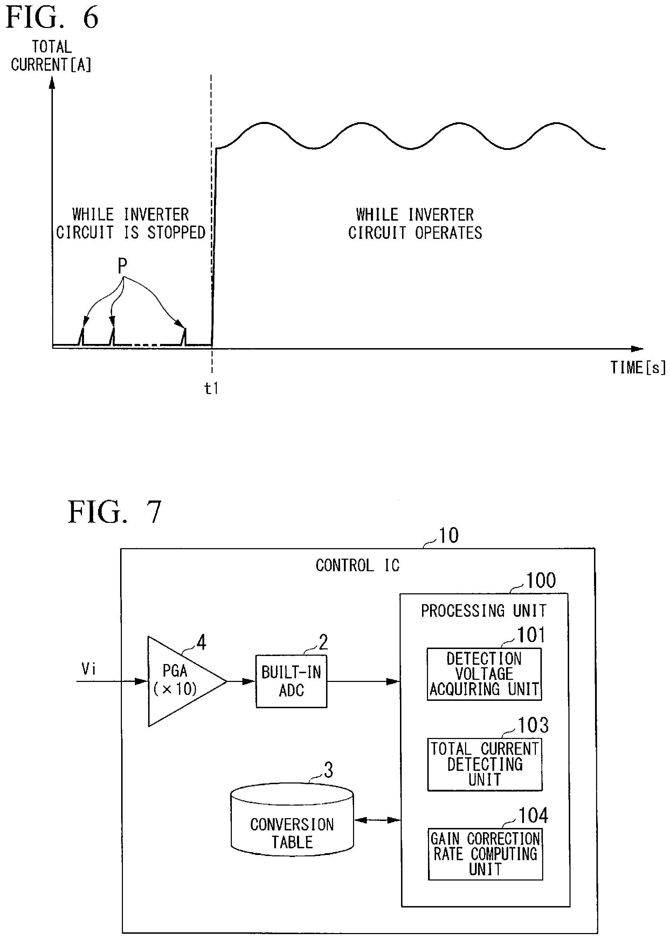

Next, a power converting device and an air conditioner according to a modified example of the first embodiment will be described with reference to Fig. 6.

Fig. 6 is a diagram describing functions of a control IC according to the modified example of the first embodiment.

Since a configuration of the power converting device 1 according to the modified example of the first embodiment is the same as in the first embodiment (Fig. 1 and Fig. 2), description thereof will be omitted.

The detection voltage acquiring unit 101 of the control IC 10 according to the modified example of the first embodiment performs moving average processing on the total current detection voltage Vi acquired when the inverter circuit 12 is stopped. In addition, when a difference between a newly acquired total current detection voltage Vi and an average value based on the moving average processing exceeds a predetermined determination threshold value, the detection voltage acquiring unit 101 performs moving average processing, excluding the total current detection voltage Vi that exceeds the determination threshold value.

In addition, the offset correction unit 102 according to the modified example of the first embodiment calculates the above-described offset value δ using an average value of the total current detection voltages Vi based on the moving average processing of the detection voltage acquiring unit 101.

As shown in Fig. 6, while the inverter circuit 12 is stopped (before time t1), since the total current Ia has a small value, an influence of periodic current noise (a peak current P) based on an operation frequency of the switching power supply 13 and the like becomes significant.

Here, when the detection voltage acquiring unit 101 accidentally acquires the total current detection voltage Vi during a generation period of the peak current P and the offset correction unit 102 calculates the offset value δ using the total current detection voltage Vi, an error including the peak current P may occur in the offset value δ. Therefore, there is actually a possibility of a detection error increasing due to an offset correction process performed while the inverter circuit 12 operates.

Therefore, the detection voltage acquiring unit 101 according to this modified example performs moving average processing on the total current detection voltage Vi that is continuously acquired while the inverter circuit 12 is stopped, and sequentially calculates an average value Viµ of the total current detection voltages Vi. Furthermore, the detection voltage acquiring unit 101 compares a total current detection voltage Vi newly acquired while the inverter circuit 12 is stopped with the average value Viµ that is already calculated. Then, when a difference (a deviation) between the newly acquired total current detection voltage Vi and the average value Viµ exceeds a predetermined determination threshold value, the detection voltage acquiring unit 101 does not include the total current detection voltage Vi when an average value is computed.

In this manner, it is possible to prevent the offset value δ calculated by the offset correction unit 102 from including an error due to the peak current P. Accordingly, it is possible to detect the total current Ia more accurately.

Also, while the inverter circuit 12 operates (after time t1), the switching power supply 13 is in a continuous operation mode and the total current Ia is relatively larger than the peak current P. Therefore, as shown in Fig. 6, an influence of the peak current P is reduced while the inverter circuit 12 operates. Accordingly, the detection voltage acquiring unit 101 according to the above-described modified example may not perform a process of eliminating an influence of the peak current P (that is, a process in which, when a deviation exceeds a predetermined determination threshold value, an average value is calculated, excluding the total current detection voltage Vi that exceeds the determination threshold value) while the inverter circuit 12 operates.

In addition, in this modified example, a form in which, when a difference between the newly acquired total current detection voltage Vi and the average value Viµ exceeds a predetermined determination threshold value, moving average processing is performed with excluding the total current detection voltage that exceeds the determination threshold value has been described. However, other embodiments are not limited to this form.

For example, the detection voltage acquiring unit 101 may increase the number of samples of the total current detection voltage Vi on which moving average processing is performed while the inverter circuit 12 is stopped to more than that when the inverter circuit 12 operates. In this manner, since it is possible to further flatten an average value of the total current detection voltages Vi while the inverter circuit 12 is stopped, it is possible to reduce the influence of the peak current P.

### <Second embodiment>

Next, a power converting device and an air conditioner according to a modified example of a second embodiment will be described with reference to Fig. 7 to Fig. 10.

### (Functional configuration of control IC)

Fig. 7 is a diagram showing a functional configuration of the control IC according to the second embodiment.

As shown in Fig. 7, the control IC 10 according to the second embodiment includes a built-in amplifier circuit (a built-in PGA 4). In addition, the control IC 10 detects the total current Ia based on an amplified voltage Va obtained by amplifying the total current detection voltage Vi in the built-in PGA 4.

According to the configuration shown in Fig. 7, the control IC 10 amplifies the input total current detection voltage Vi by a predetermined amplification factor (for example, 10 times) in the built-in PGA 4. Then, the detection voltage acquiring unit 101 according to this embodiment acquires the amplified voltage Va amplified by the built-in PGA 4 through the built-in ADC 2.

In addition, as shown in Fig. 7, the processing unit 100 of the control IC 10 according to the second embodiment includes a gain correction rate computing unit 104.

The gain correction rate computing unit 104 acquires the amplified voltage Va when the inverter circuit 12 is stopped and calculates a gain correction rate k (to be described below) for setting a value of the total current Ia corresponding to the acquired amplified voltage Va to zero.

In addition, the total current detecting unit 103 according to this embodiment detects the total current Ia generated in the power converting device 1 based on the acquired amplified voltage Va and the gain correction rate k calculated by the gain correction rate computing unit 104.

That is, the total current detecting unit 103 obtains a gain-corrected amplified voltage obtained by multiplying the amplified voltage Va by the gain correction rate k, and reads the total current detection value corresponding to the gain-corrected amplified voltage from the conversion table 3. The total current detecting unit 103 sets the total current detection value read from the conversion table 3 in this manner as a detection result of the total current Ia.

### (Specific form of conversion table)

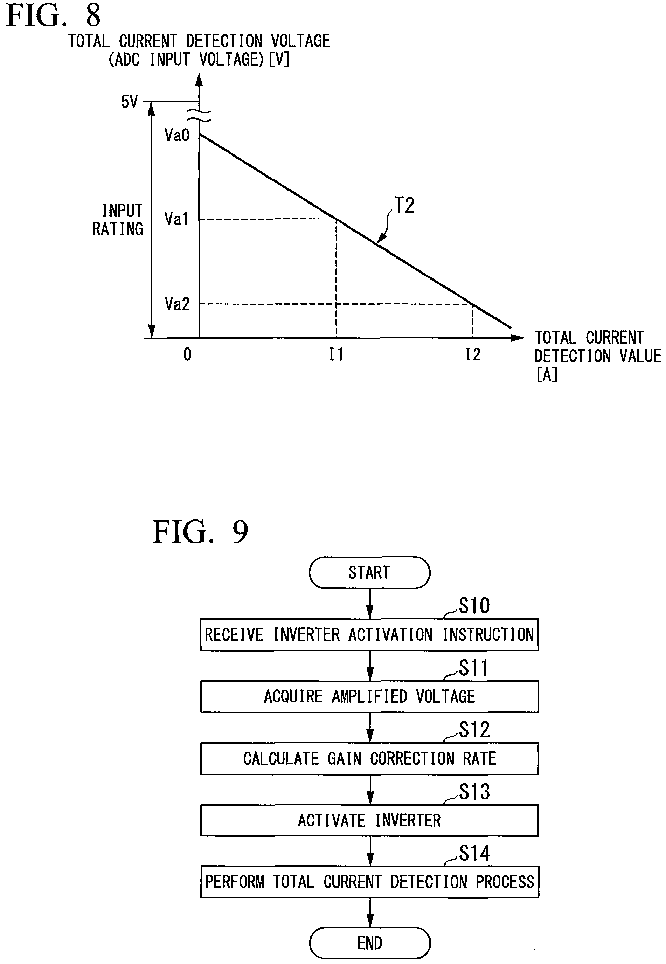

Fig. 8 is a diagram showing a specific form of the conversion table according to the second embodiment.

The graph in Fig. 8 shows information that is recorded in advance in the conversion table 3 according to the second embodiment and shows a correspondence relation between the amplified voltage Va (a voltage input to the built-in ADC 2) and the total current Ia (the total current detection value).

Here, as described above, in the total current detection voltage Vi, the amplified voltage Va is a voltage obtained by amplifying the input total current detection voltage Vi by a predetermined amplification factor (10 times).

For example, as in the first embodiment, when the resistance value of the shunt resistor Rs2 is set to 5 mΩ, the resistance value of the resistive element R1 is set to 33 kΩ, and the resistance value of the resistive element R2 is set to 2 kΩ, if the total current Ia is 20 A (=12), the total current detection voltage Vi is 190 mV, and the amplified voltage Va (=Va2) is 1.9 V. In addition, when the total current Ia is 10 A (=11), the total current detection voltage Vi is 240 mV and the amplified voltage Va (=Va1) is 2.4 V. Furthermore, when the total current Ia is 0 A, the total current detection voltage Vi is 290 mV and the amplified voltage Va (=Va0) is 2.9 V.

As described above, in addition to ideal resistance values (design values) of the resistive elements R1 and R2 and the shunt resistor Rs2, the conversion table 3 defines a relation (a characteristic T2) between the amplified voltage Va (2.9 V to 1.9 V) calculated based on an ideal amplification factor (10 times) in the built-in ADC 2 and the total current detection value (0 A to 20 A).

However, actually, the amplifier (the built-in PGA 4) built into the control IC 10 has an error of several % (for example, about ±5%) in its amplification factor. Therefore, an error according to an error of the amplification factor is assumed to occur between the total current Ia that actually flows and the total current detection value defined from the conversion table 3 based on the amplified voltage Va. Therefore, as will be described below, the control IC 10 according to this embodiment identifies an amplification factor error in advance, performs a correction process, and thus performs detection of a large current with higher accuracy.

### (Process flow and functions of control IC)

Fig. 9 is a diagram showing a process flow of the control IC according to the second embodiment.

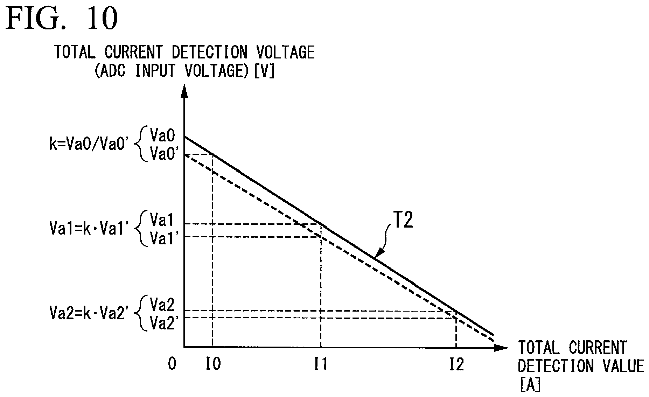

In addition, Fig. 10 is a diagram describing functions of the control IC according to the second embodiment.

The process flow shown in Fig. 9 is performed before an activation instruction of the inverter circuit 12 is issued (while the inverter circuit 12 is stopped).

Before the activation instruction of the inverter circuit 12 is issued, the control IC 10 receives an inverter activation instruction from a higher level (Step S10).

When the inverter activation instruction is received, first, the detection voltage acquiring unit 101 of the control IC 10 (Fig. 7) acquires an amplified voltage Va obtained by amplifying the total current detection voltage Vi in the built-in PGA 4 at this stage (a stage in which the inverter circuit 12 is not activated) (Step S11).

Next, the gain correction rate computing unit 104 (Fig. 7) of the control IC 10 calculates the gain correction rate k for setting the total current detection value corresponding to the amplified voltage Va to zero based on the amplified voltage Va acquired in Step S11 (Step S12).

Hereinafter, functions of the gain correction rate computing unit 104 will be described in detail with reference to Fig. 10.

As described above, an amplification factor of the built-in PGA 4 includes an intrinsic error and its actual amplification factor has an error of several % with respect to a design value (10 times). Therefore, the total current detection value acquired through the conversion table 3 (the characteristic T2) in which ideal design values are defined from the amplified voltage Va acquired in the stage in which the inverter circuit 12 is not activated (that is, a stage in which the total current Ia is actually zero) is not exactly "zero" in some cases.

Here, for example, the total current detection value acquired in the stage in which the inverter circuit 12 is not activated is "10" (I0>0) (refer to Fig. 10). Therefore, according to the characteristic T2 defined in the conversion table 3, in the stage in which the inverter circuit 12 is not activated (a stage in which the total current Ia=0), the amplified voltage Va that is actually input to the control IC 10 is defined as "Va0'" (Va0'<Va0) instead of "Va0."

The gain correction rate computing unit 104 calculates Va0/Va0' based on the amplified voltage Va (=Va0') acquired in Step S11 and calculates the gain correction rate k (=Va0/Va0'). The gain correction rate computing unit 104 records the gain correction rate k calculated here in a predetermined storage area.

Next, in Fig. 9, the control IC 10 activates the inverter circuit 12 in response to the inverter activation instruction received in Step S10 (Step S13). Therefore, in the power converting device 1, the inverter current I1 and the total current Ia flow according to the operation of the inverter circuit 12.

The detection voltage acquiring unit 101 acquires the amplified voltage Va that is obtained by amplifying the total current detection voltage Vi input through the total current detection voltage output circuit CD1 in the built-in PGA 4 while the inverter circuit 12 operates. Then, the total current detecting unit 103 acquires the total current detection value based on the amplified voltage Va acquired by the detection voltage acquiring unit 101 and the gain correction rate k calculated and recorded in Step S12 (Step S14).

Here, operations of the total current detecting unit 103 in Step S14 will be described with reference to Fig. 10.

For example, the actual total current Ia is assumed to be "I1" (11=10 A) at a certain operation time. In this case, due to an error of an amplification factor of the built-in PGA4, the amplified voltage Va output from the built-in PGA 4 is "Va1"' that is deviated from "Va1" corresponding to "I1." When the total current detecting unit 103 applies the amplified voltage Va (=Va1') input here to the characteristic T1 without change, the total current detection value obtained as a result is a value that is different from the actual total current Ia (11=10 A).

Therefore, the total current detecting unit 103 calculates a gain-corrected amplified voltage (k·Va) obtained by multiplying the amplified voltages Va that are sequentially input while the inverter circuit 12 operates by the gain correction rate k calculated in Step S12. Then, the total current detecting unit 103 acquires a total current detection value corresponding to the gain-corrected amplified voltage (k·Va) with reference to the conversion table 3.

Therefore, for example, when the total current Ia is "I1", since the gain-corrected amplified voltage (k·Va) is "Va1"(=k·Va1'), the total current detection value matches the actual total current Ia (=11). In addition, for example, when the total current Ia is "12," since the gain-corrected amplified voltage (k·Va) is "Va2" (=k·Va2'), the total current detection value matches the actual total current Ia (=12).

### (Actions and effects)

As described above, in the power converting device 1 according to the second embodiment, the control IC 10 includes the built-in amplifier circuit (the built-in PGA 4) and detects the total current Ia based on the amplified voltage Va that is obtained by amplifying the total current detection voltage Vi in the amplifier circuit.

In this manner, since a variable range of a voltage corresponding to a variable range of the total current Ia increases, it is possible to measure the total current Ia with higher accuracy.

In addition, in the power converting device 1 according to the second embodiment, the control IC 10 also acquires the amplified voltage Va when the inverter circuit 12 is stopped and calculates the gain correction rate k for setting a value of the total current Ia corresponding to the acquired amplified voltage Va to zero.

In addition, the control IC 10 detects the total current Ia based on the gain-corrected amplified voltage obtained by multiplying the amplified voltage Va acquired while the inverter circuit 12 operates by the gain correction rate k.

In this manner, since it is possible to exclude a detection error caused by an error of an amplification factor of the built-in PGA 4 and the like, it is possible to detect the total current Ia more accurately.

While the power converting device 1 according to the second embodiment has been described above in detail, a specific form of the power converting device 1 is not limited to the above-described form, and various design modifications can be added without departing from the scope of the invention.

For example, in the second embodiment, a form in which the control IC 10 (the gain correction rate computing unit 104) calculates the gain correction rate k immediately before the inverter circuit 12 is activated has been described (refer to Fig. 9). However, other embodiments are not limited to this form.

For example, the control IC 10 according to another embodiment may have a form in which the gain correction rate k is calculated immediately after an operation of the inverter circuit 12 is stopped.

In addition, in the second embodiment, a form in which the processing unit 100 of the control IC 10 has a configuration that includes the above-described gain correction rate computing unit 104 has been described. However, in other embodiments, the configuration of the gain correction rate computing unit 104 may not necessarily be installed. That is, when an error of a current detection value caused by an error of an amplification factor and the like is within an acceptable range for performing a safe operation, a form in which the total current detection value corresponding to the amplified voltage Va amplified in the built-in PGA 4 is acquired from the conversion table 3 may be used.

On the other hand, in the second embodiment, a form in which the function of the offset correction unit 102 described in the first embodiment is not included has been described. However, the power converting device 1 according to another embodiment may have a form in which both the gain correction rate computing unit 104 and the offset correction unit 102 are included and a unit to be applied may be switched according to a situation (a current signal).

In addition, the control IC 10 according to the modified example of the second embodiment may have the same function as that of the modified example of the first embodiment described using Fig. 6.

That is, the detection voltage acquiring unit 101 according to the modified example of the second embodiment performs moving average processing on the amplified voltage Va while the inverter circuit 12 is stopped (in a stage before time t1 in Fig. 6). Then, when a difference between a newly acquired amplified voltage Va and an average value Vaµ based on the moving average processing exceeds a predetermined determination threshold value, the detection voltage acquiring unit 101 may perform moving average processing with excluding the amplified voltage Va that exceeds the determination threshold value.

In addition, in general, a control IC in which an amplifier is built in can change an amplification factor of the amplifier according to internal processing of the control IC. The detection voltage acquiring unit 101 according to the modified example of the second embodiment may have a function of changing an amplification factor of the built-in PGA 4 according to whether the inverter circuit 12 is being operated or stopped.

As shown in Fig. 6, the total current Ia flowing while the inverter circuit 12 operates is a value that is extremely larger than the total current Ia while the inverter circuit is stopped. Therefore, the detection voltage acquiring unit 101 may have a form in which, while the inverter circuit 12 is stopped, an amplification factor of the built-in PGA 4 increases, while the inverter circuit 12 operates, the amplification factor decreases, and thus the amplified voltage Va is acquired.

While several embodiments of the present invention have been described above, the above-described embodiments are only examples, and are not intended to limit the scope of the invention. Variations and modifications are possible within the scope of the appended claims.

### [Reference Signs List]

1 POWER CONVERTING DEVICE
10 CONTROL IC
100 PROCESSING UNIT
101 DETECTION VOLTAGE ACQUIRING UNIT
102 OFFSET CORRECTION UNIT
103 TOTAL CURRENT DETECTING UNIT
104 GAIN CORRECTION RATE COMPUTING UNIT
11 RECTIFIER CIRCUIT
12 INVERTER CIRCUIT
13 SW POWER SUPPLY
14 PHASE ADJUSTMENT CIRCUIT
2 BUILT-IN ADC
3 CONVERSION TABLE
4 BUILT-IN PGA (AMPLIFIER CIRCUIT)
α HIGH VOLTAGE LINE
β LOW VOLTAGE LINE
CD1 TOTAL CURRENT DETECTION VOLTAGE OUTPUT CIRCUIT
Rs1, Rs2 SHUNT REGISTOR
R1, R2 RESISTIVE ELEMENT
N1 CONNECTION POINT
N2 CONNECTION POINT (FIRST CONNECTION POINT)
N3 CONNECTION POINT (SECOND CONNECTION POINT)
N4 CONNECTION POINT
LREACTOR
C CAPACITOR
D DIODE

## Claims

1. A power converting device (1) comprising:
a rectifier circuit (11) configured to generate DC power from AC power;
an inverter circuit (12) configured to generate load drive AC power from the DC power;
a high voltage line (α) and a low voltage line (β) that connect the rectifier circuit (11) and the inverter circuit (12);
a shunt resistor (Rs2) that is connected to the rectifier circuit (11) side relative to a ground point (G) along the low voltage line (β);
a total current detection voltage output circuit (CD1) configured to output a total current detection voltage corresponding to a total current (Ia) that flows toward the rectifier circuit (11) along the low voltage line (β); and
a control IC (10) configured to detect the total current (Ia) based on the total current detection voltage,
wherein the total current detection voltage output circuit (CD1) includes:
a first connection point (N2) connected to a voltage source (13) configured to apply a positive fixed voltage;
a second connection point (N3) connected between the shunt resistor (Rs2) and the rectifier circuit (11) along the low voltage line (β); and
at least two resistive elements (R1, R2) that are connected in series between the first connection point (N2) and the second connection point (N3),
wherein the total current detection voltage obtained by dividing the positive fixed voltage according to the two resistive elements (R1, R2) is output to the control IC (10), the power converting device (1) being **characterized in that** the total current detection voltage output circuit (CD1) is configured to generate the total current detection voltage so that the total current detection voltage is a positive voltage which satisfies an input rating of the control IC (10),
so that it is not necessary to invert a negative potential generated by the shunt resistor (Rs2) with respect to the ground point (G); and
wherein an inverter current (I1), that flows into the inverter circuit (12), is detected with an additional shunt resistor (Rs1) connected to the inverter circuit (12) side relative to the ground point (G) along the low voltage line (β).

2. The power converting device (1) according to claim 1,
wherein a ratio of a sum of resistance values of the two resistive elements (R1, R2) included in the total current detection voltage output circuit (CD1) to a resistance value of the shunt resistor (Rs2) is 10 to the third power or more.

3. The power converting device (1) according to claim 1 or 2,
wherein the control IC (10) is configured to acquire the total current detection voltage when the inverter circuit (12) is stopped, to calculate an offset value(s) for setting a value of the total current corresponding to the acquired total current detection voltage to zero, and to detect the total current based on an offset-corrected total current detection voltage obtained by adding the offset value to the total current detection voltage acquired while the inverter circuit (12) operates.

4. The power converting device (1) according to any one of claims 1 to 3,
wherein the control IC (10) is configured to perform moving average processing on the total current detection voltage when the inverter circuit (12) is stopped, and when a difference between the total current detection voltage that is newly acquired and an average value based on the moving average processing exceeds a predetermined determination threshold value, performs the moving average processing with excluding the total current detection voltage that exceeds the determination threshold value.

5. The power converting device (1) according to any one of claims 1 to 4,
wherein the control IC (10) includes a built-in amplifier circuit (4) and is configured to detect the total current based on an amplified voltage that is obtained by amplifying the total current detection voltage in the amplifier circuit (4).

6. The power converting device (1) according to claim 5,
wherein the control IC (10) is configured to acquire the amplified voltage when the inverter circuit (12) is stopped, calculates a gain correction rate (k) for setting a value of the total current corresponding to the acquired amplified voltage to zero, and to detect the total current based on a gain-corrected amplified voltage obtained by multiplying the amplified voltage acquired while the inverter circuit (12) operates by the gain correction rate (k).

7. An air conditioner comprising the power converting device (1) according to any one of claims 1 to 6.

## Patentansprüche

1. Energieumwandlungsvorrichtung (1), umfassend:
eine Gleichrichterschaltung (11), die konfiguriert ist, um Gleichstrom von Wechselstrom zu erzeugen;
eine Wechselrichterschaltung (12), die konfiguriert ist, um aus der Gleichstromleistung eine Lastantriebs-Wechselstromleistung zu erzeugen;
eine Hochspannungsleitung (α) und eine Niederspannungsleitung (β), die die Gleichrichterschaltung (11) und die Wechselrichterschaltung (12) verbinden;
einen Shunt-Widerstand (Rs2), der mit der Seite der Gleichrichterschaltung (11) relativ zu einem Massepunkt (G) entlang der Niederspannungsleitung (β) verbunden ist;
eine Gesamtstrom-Erfassungsspannungs-Ausgabeschaltung (CD1), die konfiguriert ist, um eine Gesamtstrom-Erfassungsspannung entsprechend einem Gesamtstrom (Ia) auszugeben, der in Richtung der Gleichrichterschaltung (11) entlang der Niederspannungsleitung (β) fließt; und
und eine Steuer-IC (10), die konfiguriert ist, um den Gesamtstrom (Ia) basierend auf der Gesamtstrom-Erfassungsspannung zu erfassen,
wobei die Gesamtstrom-Erfassungsspannungs-Ausgabeschaltung (CD1) umfasst:
einen ersten Verbindungspunkt (N2), verbunden mit einer Spannungsquelle (13), konfiguriert zum Anlegen einer positiven festen Spannung;
einen zweiten Verbindungspunkt (N3), der zwischen dem Shunt-Widerstand (Rs2) und der Gleichrichterschaltung (11) entlang der Niederspannungsleitung (β) geschaltet ist; und
mindestens zwei Widerstandselemente (R1, R2), die zwischen dem ersten Verbindungspunkt (N2) und dem zweiten Verbindungspunkt (N3) in Reihe geschaltet sind,
wobei die Gesamtstrom-Erfassungsspannung, erlangt durch Division der positiven festen Spannung gemäß den zwei Widerstandselementen (R1, R2), an die Steuer-IC (10) ausgegeben wird, wobei die Energieumwandlungsvorrichtung (1) **dadurch gekennzeichnet ist, dass** die Gesamtstrom-Erfassungsspannungs-Ausgabeschaltung (CD1) konfiguriert ist zum Erzeugen der Gesamtstrom-Erfassungsspannung, so dass die Gesamtstrom-Erfassungsspannung eine positive Spannung ist, die eine Eingangsleistung der Steuer-IC (10) erfüllt, so dass es nicht erforderlich wird, ein vom Shunt-Widerstand (Rs2) erzeugtes negatives Potential in Bezug auf den Massepunkt (G) umzuwandeln; und
wobei ein Wechselrichterstrom (I1), der in die Wechselrichterschaltung (12) fließt, mit einem zusätzlichen Shunt-Widerstand (Rs1) erfasst wird, der mit der Seite der Wechselrichterschaltung (12) relativ zum Massepunkt (G) entlang der Niederspannungsleitung (β) verbunden ist.

2. Energieumwandlungsvorrichtung (1) nach Anspruch 1 wobei ein Verhältnis einer Summe von Widerstandswerten der zwei Widerstandselemente (R1, R2), die in der Gesamtstrom-Erfassungsspannungs-Ausgabeschaltung (CD1) enthalten sind, zu einem Widerstandswert des Shunt-Widerstands (Rs2) 10 zur dritten Leistung oder mehr ist.

3. Energieumwandlungsvorrichtung (1) nach Anspruch 1 oder 2,
wobei die Steuer-IC (10) konfiguriert ist zum Erfassen der Gesamtstrom-Erfassungsspannung, wenn die Wechselrichterschaltung (12) angehalten ist, um einen Offset-Wert (s) zum Einstellen eines Werts des Gesamtstroms zu berechnen, der der erfassten Gesamtstrom-Erfassungsspannung entspricht, auf null, und zum Erfassen des Gesamtstroms basierend auf einer Offset-korrigierten Gesamtstrom-Erfassungsspannung, die durch Addieren des Offsetwerts zu der erfassten Gesamtstrom-Erfassungsspannung erlangt wird, während die Wechselrichterschaltung (12) arbeitet.

4. Energieumwandlungsvorrichtung (1) nach einem der Ansprüche 1 bis 3,
wobei die Steuer-IC (10) konfiguriert ist zum Durchführen einer gleitenden Mittelwertverarbeitung an der Gesamtstrom-Erfassungsspannung, wenn die Wechselrichterschaltung (12) angehalten ist, und wenn eine Differenz zwischen der Gesamtstrom-Erfassungsspannung, die kürzlich erfasst worden ist, und ein auf der gleitenden Mittelwertbildung basierenden Durchschnittswert einen im Voraus bestimmten Bestimmungsschwellenwert überschreitet, Durchführen der gleitenden Mittelwertverarbeitung bei Ausschließen der Gesamtstrom-Erfassungsspannung die den Bestimmungsschwellenwert überschreitet.

5. Energieumwandlungsvorrichtung (1) nach einem der Ansprüche 1 bis 4,
wobei die Steuer-IC (10) eine eingebaute Verstärkerschaltung (4) aufweist und konfiguriert ist zum Erfassen des Gesamtstroms basierend auf einer verstärkten Spannung, die durch Verstärken der Gesamtstrom-Erfassungsspannung in der Verstärkerschaltung (4) erlangt wird.

6. Energieumwandlungsvorrichtung (1) nach Anspruch 5,
wobei die Steuer-IC (10) konfiguriert ist zum Erfassen der verstärkten Spannung, wenn die Wechselrichterschaltung (12) angehalten ist, Berechnen einer Verstärkungskorrekturrate (k) zum Einstellen eines Werts des Gesamtstroms entsprechend der erfassten verstärkten Spannung auf null, und zum Erfassen des Gesamtstroms basierend auf einer verstärkungskorrigierten verstärkten Spannung, die durch Multiplikation der erfassten verstärkten Spannung erlangt wird, während die Wechselrichterschaltung (12) durch die Verstärkungskorrekturrate (k) arbeitet.

7. Klimaanlage, umfassend die Energieumwandlungsvorrichtung (1) nach einem der Ansprüche 1 bis 6.

## Revendications

1. Dispositif de conversion de puissance (1) comprenant :
un circuit de redressement (11) configuré pour générer un courant continu à partir d'un courant alternatif ;
un circuit onduleur (12) configuré pour générer un courant alternatif de commande de charge à partir du courant continue ;
une ligne de haute tension (α) et une ligne de faible tension (β) qui connectent le circuit de redressement (11) et le circuit onduleur (12) ;
une résistance de dérivation (Rs2) qui est connectée au côté du circuit de redressement (11) par rapport à un point de masse (G) le long de la ligne de faible tension (β) ;
un circuit de sortie de tension de détection de courant total (CD1) configuré pour délivrer une tension de détection de courant total correspondant à un courant total (Ia) qui circule vers le circuit de redressement (11) le long de la ligne de faible tension (β) ; et
un circuit intégré de commande (10) configuré pour détecter le courant total (Ia) sur la base de la tension de détection de courant total,
dans lequel le circuit de sortie de tension de détection de courant total (CD1) comprend :
un premier point de connexion (N2) connecté à une source de tension (13) configurée pour appliquer une tension fixe positive ;
un deuxième point de connexion (N3) connecté entre la résistance de dérivation (Rs2) et le circuit de redressement (11) le long de la ligne de faible tension (β) ; et
au moins deux éléments résistifs (R1, R2) qui sont connectés en série entre le premier point de connexion (N2) et le deuxième point de connexion (N3),
dans lequel la tension de détection de courant total obtenue en divisant la tension fixe positive conformément aux deux éléments résistifs (R1, R2) est délivrée au circuit intégré de commande (10), le dispositif de conversion de puissance (1) étant **caractérisé en ce que** le circuit de sortie de tension de détection de courant total (CD1) est configuré pour générer la tension de détection de courant total de sorte que la tension de détection de courant total soit une tension positive qui satisfait à une entrée donnée du circuit intégré de commande (10), de sorte qu'il n'est pas nécessaire d'inverser un potentiel négatif généré par la résistance de dérivation (Rs2) par rapport au point de masse (G) ; et
dans lequel un courant d'onduleur (I1), qui circule dans le circuit onduleur (12), est détecté par une résistance de dérivation supplémentaire (Rs1) connectée au côté du circuit onduleur (12) par rapport au point de masse (G) le long de la ligne de faible tension (β).

2. Dispositif de conversion de puissance (1) selon la revendication 1,
dans lequel un rapport entre une somme des valeurs de résistance des deux éléments résistifs (R1, R2) inclus dans le circuit de sortie de tension de détection de courant total (CD1) et une valeur de résistance de la résistance de dérivation (Rs2) est 10 à la troisième puissance ou plus.

3. Dispositif de conversion de puissance (1) selon la revendication 1 ou 2,
dans lequel le circuit intégré de commande (10) est configuré pour acquérir la tension de détection de courant total lorsque le circuit onduleur (12) est arrêté, pour calculer une valeur (s) de décalage pour établir une valeur du courant total correspondant à la tension de détection de courant total acquise à zéro, et pour détecter le courant total sur la base d'une tension de détection de courant total à décalage corrigé obtenue en ajoutant la valeur de décalage à la tension de détection de courant total acquise alors que le circuit onduleur (12) fonctionne.

4. Dispositif de conversion de puissance (1) selon l'une quelconque des revendications 1 à 3,
dans lequel le circuit intégré de commande (10) est configuré pour effectuer un traitement de moyenne mobile sur la tension de détection de courant total lorsque le circuit onduleur (12) est arrêté, et lorsqu'une différence entre la tension de détection de courant total qui est nouvellement acquise et une valeur moyenne basée sur le traitement de moyenne mobile dépasse une valeur de seuil de détermination prédéterminée, effectuer le traitement de moyenne mobile à l'exclusion de la tension de détection de courant total qui dépasse la valeur de seuil de détermination.

5. Dispositif de conversion de puissance (1) selon l'une quelconque des revendications 1 à 4,
dans lequel le circuit intégré de commande (10) comprend un circuit d'amplificateur intégré (4) et est configuré pour détecter le courant total sur la base d'une tension amplifiée qui est obtenue en amplifiant la tension de détection de courant total dans le circuit d'amplificateur (4).

6. Dispositif de conversion de puissance (1) selon la revendication 5,
dans lequel le circuit intégré de commande (10) est configuré pour acquérir la tension amplifiée lorsque le circuit onduleur (12) est arrêté, calculer un taux de correction de gain (k) pour établir une valeur du courant total correspondant à la tension amplifiée acquise à zéro, et pour détecter le courant total sur la base d'une tension amplifiée à gain corrigé obtenue en multipliant la tension amplifiée acquise alors que le circuit onduleur (12) fonctionne par le taux de correction de gain (k).

7. Climatiseur comprenant le dispositif de conversion de puissance (1) selon l'une quelconque des revendications 1 à 6.
